# EUROPEAN PATENT APPLICATION

(11) **EP 4 553 512 A1**
(43) Date of publication of application: **14.05.2025**
(21) Application number: 23209245.2
(22) Date of filing: 10.11.2023
(51) Int. Cl.: G01R 31/3185

(54) **A DIGITAL COMMUNICATION INTERFACE EMULATOR**

(71) Applicant: Koninklijke Fabriek Inventum B.V., 3992 AD Houten (NL)
(72) Inventor: REMEEUS, Richard, Eindhoven (NL)
(74) Representative: Dehns

(57) **Abstract**

A digital communication interface emulator for a platform, the digital communication interface emulator comprising: a Joint Test Action Group (JTAG) library module configured to produce JTAG data, wherein the JTAG data comprises communication instructions; and a JTAG driver module configured to transmit the JTAG data to a JTAG compatible chip, the JTAG compatible chip connected to a target chip via a JTAG communication pin of the JTAG compatible chip and a target communication pin of the target chip, wherein the communication instructions are configured to cause the JTAG compatible chip to communicate with the target chip via the JTAG communication pin, such that the platform can communicate with the target chip via the digital communication interface emulator and the JTAG compatible chip.

## Description

### Technical Field

This disclosure relates to a digital communication interface emulator, a platform, a digital communicator interface system, a system, a computer-readable medium and a method.

### Background

Many microchips (also referred to as chips) comprise a Joint Test Action Group (JTAG) interface, which is often used during the assembly of a printed circuit board (PCB) and for debugging/programming during use. The JTAG interface generally comprises four or five pins, and is configured such that the JTAG lines of multiple chips can be daisy-chained together. JTAG connections have potentially useful characteristics, such as the ability to bypass the normal operating purpose of a chip, and a boundary scan feature allowing any of the other pins on a chip to be controlled.

Some types of chips are non-JTAG compatible, meaning they cannot connect to the JTAG interface. These chips require the use of non-JTAG communication protocols, with data transmitted via non-JTAG pins when being programmed or debugged. However, it may be difficult to access the non-JTAG pins of the chip during or after manufacture.

### Summary

According to a first aspect, there is provided a digital communication interface emulator for a platform, the digital communication interface emulator comprising: a Joint Test Action Group (JTAG) library module configured to produce JTAG data, wherein the JTAG data comprises communication instructions; and a JTAG driver module configured to transmit the JTAG data to a JTAG compatible chip, the JTAG compatible chip connected to a target chip via a JTAG communication pin of the JTAG compatible chip and a target communication pin of the target chip, wherein the communication instructions are configured to cause the JTAG compatible chip to communicate with the target chip via the JTAG communication pin, such that the platform can communicate with the target chip via the digital communication interface emulator and the JTAG compatible chip, wherein the target communication pin is a universal asynchronous receiver-transmitter pin (UART), wherein the JTAG data is configured to cause the JTAG compatible chip to communicate with the target chip using a UART communication protocol.

The target chip may be a non-JTAG chip and the communication instructions are configured to cause the JTAG compatible chip to communicate with the target chip via a non-JTAG communication protocol.

This allows for communication between the platform and the target chip in circumstances where the target chip may not have otherwise been readily accessible (e.g. emulating the interface to the target using required software libraries).

The communication instructions may cause the JTAG chip to communicate with the target chip using boundary scan functionality.

The UART communication protocol may be a universal synchronous/asynchronous receiver-transmitter (USART) communication protocol.

The UART communication protocol may comprise hardware flow control. The hardware flow control may comprise ready to send (RTS) and/or clear to send (CTS) flow control.

The JTAG library module may be configured to receive input data, the JTAG library module configured to process the input data to produce the JTAG data.

The input data may comprise information relating to a connection between the JTAG compatible chip and the target chip.

The input data may comprise programming and/or debugging data, wherein the JTAG library module is configured to produce output data corresponding to the input data such that the JTAG data comprises the output data, wherein the communication instructions are configured to cause the JTAG chip to transmit the output data to the target chip to program and/or debug the target chip.

The input data may be non-JTAG data.

The communication instructions may be configured to cause the JTAG compatible chip to communicate with the target chip via the communication pin, such that the platform can transmit data to and/or receive data from with the target chip via the digital communication interface emulator and the JTAG compatible chip.

According to a second aspect, there is provided a platform comprising the digital communication interface emulator of the first aspect.

According to a third aspect, there is provided a digital communication interface system comprising the digital communication interface emulator of the first aspect or the platform of the second aspect and a JTAG controller, wherein the JTAG controller is configured to receive the JTAG data from the JTAG driver module and transmit the JTAG data to the JTAG compatible chip.

According to a fourth aspect, there is provided a system comprising: the digital communication interface emulator of the first aspect or the digital communication interface system of the third aspect; and a target module, the target module comprising the JTAG compatible chip and the target chip.

The target module may be a wireless communication module configured to transmit and/or receive wireless data.

The target communication pin may be configured to transmit and/or receive the wireless data.

According to a fifth aspect, there is provided a computer readable medium comprising instructions which, when executed by processing circuitry of a digital communicator interface emulator, cause the digital communicator interface system to: produce JTAG data, wherein the JTAG data comprises communication instructions; and transmit the JTAG data to a JTAG compatible chip, the JTAG compatible chip connected to a target chip via a JTAG communication pin of the JTAG compatible chip and a target communication pin of the target chip, wherein the communication instructions are configured to cause the JTAG compatible chip to communicate with the target chip via the JTAG communication pin.

According to a sixth aspect, there is provided a method for communicating between a platform and a target chip comprising: producing JTAG data, wherein the JTAG data comprises communication instructions; transmitting the JTAG data to a JTAG compatible chip, the JTAG compatible chip connected to the target chip via a JTAG communication pin of the JTAG compatible chip and a target communication pin of the target chip, the communication instructions causing the JTAG compatible chip to communicate with the target chip via the communication pin; and communicating, by the platform, with the target chip via the JTAG compatible chip.

### Brief Description of the Drawings

Various examples will now be described, by way of example only, and with reference to the accompanying drawings, in which:
Fig. 1 shows a diagram of a system comprising a platform and a target module; and
Fig. 2 shows a flow diagram of a method for communicating between a platform and a target module.

### Detailed Description

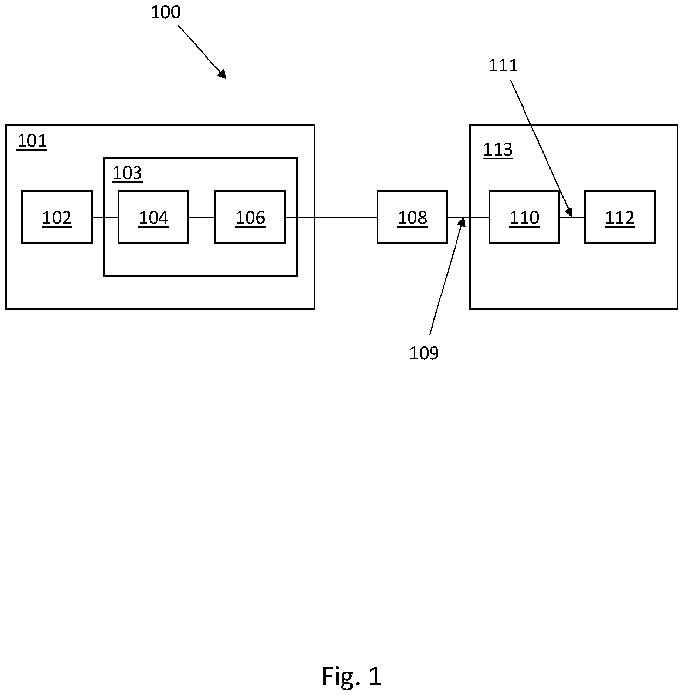

Referring to Fig. 1, a diagram of a system 100 comprising a platform 101 and a target module 113 is shown. The system further comprises a JTAG controller 108. The platform 101 is connected to the target module 113 via the JTAG controller 108. The platform 101 comprises an input module 102 and a digital communication interface emulator 103, wherein the digital communication interface emulator 103 comprises a JTAG library module 104 and a JTAG driver module 106. In this embodiment, the platform 101 is a computer. In alternative embodiments, the platform 101 may be a device connected to a computer or any other compatible device (e.g. a microcontroller or FPGA). In these alternative embodiments, the input module 102 may still be comprised in the computer. In some embodiments, the platform may comprise the JTAG controller 108. The digital communication interface emulator 103 may further comprise other libraries and/or software to support the proper translation of JTAG data to the input module 102. The target module 113 comprises a JTAG compatible chip 110 and a target chip 112. In this embodiment, the target module 113 is a wireless communication module configured to transmit and/or receive wireless data. In some embodiments, the wireless data may be operational data, wherein the operational data may be used for: vehicle (e.g. Aircraft) communication; communication with other modules within the vehicle; and/or allowing passengers to communicate via personal devices. The operational data may not be for programming and/or debugging modules in the vehicle (e.g. the aircraft).

In this embodiment, the input module 102 is directly connected to the JTAG library module 104. The input module 102 comprises a control interface (for example a keyboard and a mouse) such that the input module 102 can receive inputs from a user. The input module 102 is configured to produce input data, wherein the input data may be non-JTAG data. More specifically, the input data may be of the same form as data transmitted between the JTAG compatible chip 110 and the target chip 112. The connection between the input module 102 and digital communication interface emulator 103 may be considered to operate as a 'virtual COM-port' (e.g. when utilizing UART), with the input module 102 communicating in the same manner as it would via a COM-port.

The JTAG library module 104 is directly connected to the input module 102 and the JTAG driver module 106. The JTAG library module 104 is a module configured to produce JTAG data, wherein the JTAG data comprises communication instructions. To do this, the JTAG library module 104 is configured to receive the input data. The input data comprises programming and/or debugging data, which is usable to program and/or debug the target chip 112. The input data further comprises information relating to a connection 111 between the JTAG compatible chip 110 and the target chip 112, which may originate from the inputs received by the input module 102. More specifically, the information may relate to which pins of the JTAG compatible chip 110 and the target chip 112 are connected together, and the form of the data that the target chip 112 is configured to receive. In some embodiments, the pins of the JTAG compatible chip 110 and the target chip 112 which are connected (and/or the parameters required for their connection, e.g. a speed setting) may be known before the transmission and/or receipt of the input data, such that the connection 111 is preconfigured. The JTAG library module 104 is further configured to process the input data to produce the JTAG data. The JTAG library module 104 is further configured to produce output data corresponding to the input data, such that the JTAG data comprises the output data.

The JTAG driver module 106 is directly connected to the JTAG library module 104 and the JTAG controller 108. The JTAG driver module 106 is a module configured to transmit the JTAG data to the JTAG compatible chip 110.

The JTAG controller 108 is directly connected to the JTAG driver module 106 and the JTAG compatible chip 110. The JTAG controller 108 is configured to receive the JTAG data from the JTAG driver module 106 and transmit the JTAG data to the JTAG compatible chip 110 using a JTAG interface 109.

The JTAG compatible chip 110 is connected to the target chip 112 via a JTAG communication pin of the JTAG compatible chip 110 and a target communication pin of the target chip 112. In some embodiments, the target communication pin may not be accessible from outside the target module 113, for example the target communication pin may be internal to the target module 113.

The communication instructions of the JTAG data are configured to cause the JTAG compatible chip 110 to communicate with the target chip 112 via the JTAG communication pin, such that the platform 101 can communicate with the target chip 112 via the digital communication interface emulator 103 and the JTAG compatible chip 110. This means the platform 101 can transmit data to and/or receive data from the target chip 112 via the digital communication interface emulator 103 and the JTAG compatible chip 110. More specifically, the communication instructions cause the JTAG compatible chip 110 to transmit the output data to the target chip 112, to program and/or debug the target chip 112. In other embodiments, the platform 101 may only receive data from the target chip 112 via the digital communication interface emulator 103 and the JTAG compatible chip 110. In other embodiments, the platform 101 may both transmit to and receive data from the target chip 112 via the digital communication interface emulator 103 and the JTAG compatible chip 110.

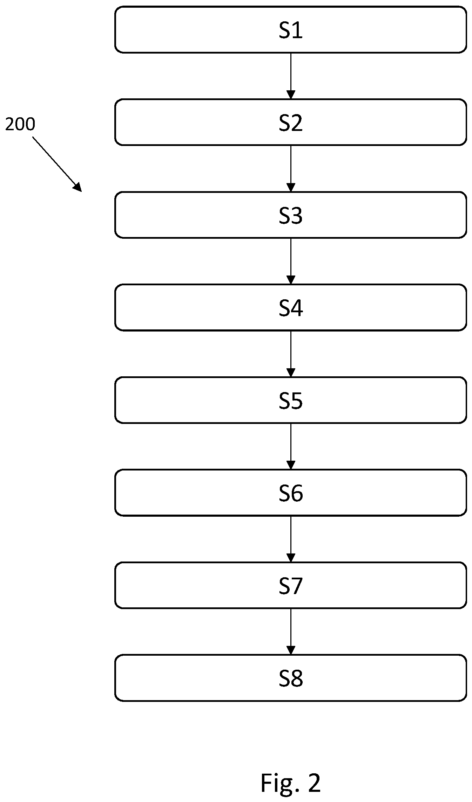

The target chip 112 may be a non-JTAG chip, meaning the target communication pin is a non-JTAG pin. The communication instructions may be configured to cause the JTAG compatible chip 110 to communicate with the target chip 112 using a non-JTAG communication protocol 111. In this embodiment, the target communication pin is a universal asynchronous receiver-transmitter (UART) pin, wherein the communication instructions are configured to cause the JTAG compatible chip 110 to communicate with the target chip 112 using UART communication protocol 111. This is achieved by using the information relating to the connection between the JTAG compatible chip 110 and the target chip 112 to determine which type of non-JTAG communication protocol is required. The communication instructions then cause the JTAG communication pin (e.g. using JTAG boundary scan functionality) to transmit the output data using a communication protocol that can be received by the target communication pin. In this embodiment, this means the JTAG communication pin transmits data in a form and at a rate which can be received and used by the UART pin of the target chip 112. This may not be a rate used by the JTAG communication pin during standard operation (see Fig. 2). In other embodiments, the target communication pin may be a SPI, I²C, SAI, CAN, USB or Ethernet pin. The corresponding communication protocol 111 used between the JTAG compatible chip 110 and the target chip 112 may therefore be SPI, I²C, SAI, CAN, USB or Ethernet. In some embodiments, the JTAG compatible chip 110 may also communicate with a target chip using at least one of these communication protocols in addition to communicating via UART.

In some embodiments, the JTAG compatible chip 110 may be configured to receive response data from the target chip 112. The JTAG compatible chip 110 may be configured to process the response data to produce JTAG response data. The JTAG controller 108 may be configured to receive the JTAG response data from the JTAG compatible chip 110. The JTAG library module 104 may be configured to receive the JTAG response data from the JTAG controller module 108 via the JTAG driver module 106. The JTAG library module 104 may be configured to process the JTAG response data to produce output response data. The input module 102 may be configured to receive the output response data from the JTAG library module 104. In this way, the input module 102 may be configured to receive data from the target chip 112 as well as transmitting data to it. In some examples, the input module 102 may be configured to receive data from the target chip 112 without transmitting data to the target chip 112.

Referring to Fig. 2, a flow diagram of a method for communicating between a platform 101 and a target module 113 is shown. The method comprises a first normal operating stage S1, a connecting stage S2, an input stage S3, a processing stage S4, a first transmission stage S5, a second transmission stage S6, an action stage S7 and a second normal operating stage S8.

In the first normal operating stage S1, the target module 113 operates to serve its intended functions. For example, as mentioned above, the target module 113 may provide communication (e.g. wireless communication) on a vehicle such as an aircraft. In order to do this, wireless communication data may be transmitted via the target communication pin of the target chip 112.

The connecting stage S2 comprises connecting the platform 101 to the target module 113. More specifically, the JTAG driver module 106 of the platform 101 is connected to the JTAG compatible chip 110 of the target module 113. This connection may be made via the JTAG controller 108, and utilise a JTAG interface.

The input stage S3 comprises the platform 101 receiving the input data. More specifically, the input stage S3 comprises the input module 102 receiving inputs from a user via the control interface to produce the input data, and the JTAG library module 104 receiving the input data. In other examples, the input data may include data stored in the platform 101 (e.g. where the information relating to the connection 111 between the JTAG compatible chip 110 and the target chip 112 is already known and stored in the platform 101).

The processing stage S4 comprises the JTAG library module 104 processing the input data to produce the JTAG data comprising the communication instructions and the output data.

The first transmission stage S5 comprises the platform 101 transmitting the JTAG data to the target module 113. More specifically, the first transmission stage S5 comprises the JTAG driver module 106 transmitting the JTAG data to the JTAG compatible chip 110 of the target module 113.

The second transmission stage S6 comprises the JTAG compatible chip 110 transmitting the output data to the target chip 112 using the communication protocol specified by the communication instructions. The output data is transmitted from the JTAG communication pin of the JTAG compatible chip 100 to the target communication pin of the target chip 112. In this embodiment, the output data is transmitted using the UART communication protocol.

The action stage S7 comprises the output data being received by the target communication pin of the target chip 112, the output data causing an action to be executed by the target chip 112, for example programming or debugging of the target chip 112.

In some embodiments, the action stage S7 may further comprise the communication pin of the target chip 112 transmitting response data back to the JTAG communication pin of the JTAG compatible chip 110 via the same communication protocol used to transfer the output data from the JTAG compatible chip 110 to the target chip 112 (for example, UART communication protocol). The response data may then be processed at the JTAG compatible chip 110 to produce JTAG response data, before the JTAG response data is transmitted back to the JTAG library module 104 via the JTAG controller 108 and JTAG driver module 106, using the JTAG interface. The JTAG response data may then be processed at the JTAG library module 104 to produce output response data, wherein the output response data may be of the same form as the response data. The output response data may then be received by the input module 102, where it can be viewed by a user. In some embodiments, the response data may be produced autonomously (i.e. the production of response data may not be preceded by the receipt of output data by the target chip 112).

In some embodiments, the process of debugging the target chip 112 may comprise the output data causing the target chip 112 to issue a command to illuminate an element, for example an LED. If the LED does not illuminate when the target chip 112 receives the output data, this indicates to the user that an error has occurred.

After the action caused by the output data has been executed, the second normal operating stage S8 begins, wherein the target module 113 returns to its standard operation. In some embodiments, the second normal operating stage S8 may be the same as the first normal operating stage S1.

In some embodiments, stages S1 to S7 may occur in a different order to that stated above.

Various aspects disclosed in the various examples may be used alone, in combination, or in a variety of arrangements not specifically discussed in the examples described in the foregoing and this disclosure is therefore not limited in its application to the details and arrangement of components set forth in the foregoing description or illustrated in the drawings. For example, aspects described in one example may be combined in any manner with aspects described in other examples. Although particular examples have been shown and described, it will be obvious to those skilled in the art that changes and modifications may be made without departing from the invention in its broader aspects. The scope of the following claims should not be limited by the examples set forth in the examples, but should be given the broadest reasonable interpretation consistent with the description as a whole.

## Claims

1. A digital communication interface emulator for a platform the digital communication interface emulator comprising:
a Joint Test Action Group (JTAG) library module configured to produce JTAG data, wherein the JTAG data comprises communication instructions; and
a JTAG driver module configured to transmit the JTAG data to a JTAG compatible chip, the JTAG compatible chip connected to a target chip via a JTAG communication pin of the JTAG compatible chip and a target communication pin of the target chip,
wherein the communication instructions are configured to cause the JTAG compatible chip to communicate with the target chip via the JTAG communication pin, such that the platform can communicate with the target chip via the digital communication interface emulator and the JTAG compatible chip
wherein the target communication pin is a universal asynchronous receiver-transmitter pin (UART), wherein the communication instructions are configured to cause the JTAG compatible chip to communicate with the target chip using a UART communication protocol.

2. The digital communication interface emulator of claim 1, wherein the target chip is a non-JTAG chip and the communication instructions are configured to cause the JTAG compatible chip to communicate with the target chip via a non-JTAG communication protocol.

3. The digital communication interface emulator of any preceding claim, wherein the UART communication protocol is a universal synchronous/asynchronous receiver-transmitter (USART) communication protocol.

4. The digital communication interface emulator of any preceding claims, wherein the JTAG library module is configured to receive input data, the JTAG library module configured to process the input data to produce the JTAG data.

5. The digital communication interface emulator of claim 4, wherein the input data comprises information relating to a connection between the JTAG compatible chip and the target chip.

6. The digital communication interface emulator of claim 3 or 4, wherein the input data comprises programming and/or debugging data, wherein the JTAG library module is configured to produce output data corresponding to the input data such that the JTAG data comprises the output data, wherein the communication instructions are configured to cause the JTAG chip to transmit the output data to the target chip to program and/or debug the target chip.

7. The digital communication interface emulator according to any of claims 5 to 7, wherein the input/output data is non-JTAG data.

8. The digital communication interface emulator of any preceding claim, wherein the communication instructions are configured to cause the JTAG compatible chip to communicate with the target chip via the communication pin, such that the platform can transmit data to and/or receive data from the target chip via the digital communication interface emulator and the JTAG compatible chip

9. A platform comprising the digital communication interface emulator of any preceding claim.

10. A digital communication interface system comprising the digital communication interface emulator of any of claims 1 to 9 or the platform of claim 10 and a JTAG controller, wherein the JTAG controller is configured to receive the JTAG data from the JTAG driver module and transmit the JTAG data to the JTAG compatible chip.

11. A system comprising:
the digital communication interface emulator of any of claims 1 to 8, the platform of claim 10 or the digital communicator interface system of claim 11; and
a target module, the target module comprising the JTAG compatible chip and the target chip.

12. A system according to claim 11, wherein the target module is a wireless communication module configured to transmit and/or receive wireless data.

13. A system according to claim 12, wherein the target communication pin is configured to transmit and/or receive the wireless data.

14. A computer-readable medium comprising instructions which, when executed by processing circuitry of a digital communicator interface emulator, cause the digital communicator interface system to:
produce JTAG data, wherein the JTAG data comprises communication instructions;
transmit the JTAG data to a JTAG compatible chip, the JTAG compatible chip connected to a target chip via a JTAG communication pin of the JTAG compatible chip and a target communication pin of the target chip, wherein the communication instructions are configured to cause the JTAG compatible chip to communicate with the target chip via the JTAG communication pin.

15. A method for communicating between a platform and a target chip comprising:
producing JTAG data, wherein the JTAG data comprises communication instructions;
transmitting the JTAG data to a JTAG compatible chip, the JTAG compatible chip connected to the target chip via a JTAG communication pin of the JTAG compatible chip and a target communication pin of the target chip, the communication instructions causing the JTAG compatible chip to communicate with the target chip via the communication pin; and
communicating, by the platform, with the target chip via the JTAG compatible chip.
